# EUROPEAN PATENT APPLICATION

(11) **EP 4 693 907 A1**
(43) Date of publication of application: **11.02.2026**
(21) Application number: 25194649.7
(22) Date of filing: 07.08.2025

(54) **LOOP POWER DRIVER FOR FIRE SAFETY SYSTEMS**

(30) Priority: 08.08.2024 US 202463680919 P
(71) Applicant: Kidde Fire Protection, LLC, Bradenton, FL 34202 (US)
(72) Inventor: KALAVADIA, Owen Sound, ON N4K 5P8 (CA); VANGARI, Sunil Kumar, Hyderabad, 500081 (IN); ROBOTHAM, Martin, Bradenton, FL 34202 (US)
(74) Representative: Dehns

(57) **Abstract**

Described herein is a loop power driver (200) for communication and power supply. The driver (200) comprises a first transistor (202) and a second transistor (204) configured in a push-pull configuration, a high-power electronic switch (206) configured parallel to the first transistor (202), and an operational amplifier, OpAmp, (208) connected to the first transistor (202) and the second transistor (205). A controller (106) is connected to the switch (206) and the OpAmp (208), wherein the controller (106) comprises a processor with access to a memory storing instructions executable by the processor, which causes the controller (106) to issue a first actuation signal to operate the driver (200) in a first mode that enables supply of electrical power signals above a predefined voltage level via the line, and issue a second actuation signal to operate the driver (200) in a second mode that enables supply of power and communication signals below the predefined voltage level and at a predefined speed via the line.

## Description

### BACKGROUND

Embodiments described herein relate to the field of loop drivers, and more particularly, a high-power and high-speed loop power driver for fire safety systems, which may enable power supply and communication using a common line.

### SUMMARY

The present invention provides a loop power driver for communication and power supply. The loop power driver comprises a first transistor and a second transistor configured in a push-pull configuration, a high-power electronic switch configured parallel to the first transistor, an operational amplifier (OpAmp) comprising an input terminal connected to a digital to analog converter (DAC), and output terminals connected to bases associated with the first transistor and the second transistor, wherein the driver is adapted to be configured in a power and communication line associated with a field equipment loop, such that the switch and the first transistor remain configured in series with the line, and the second transistor remains configured between the line and ground at an output end of the driver. A controller is connected to the switch and the DAC, wherein the controller comprises a processor with access to a memory storing instructions executable by the processor, which causes the controller to issue a first actuation signal to operate the driver in a first mode that enables supply of electrical power signals above a predefined voltage level via the line, and issue a second actuation signal to operate the driver in a second mode that enables supply of power and communication signals below the predefined voltage level and at a predefined speed via the line.

Optionally, the driver is configured in the line, such that a collector of the first transistor remains connected to the line at an input end of the driver, emitters of the first transistor and the second transistor remain connected to the line at the output end of the driver, the switch remains parallel to the first transistor between the collector and the emitter of the first transistor, and a collector of the second transistor remains connected to the ground at the output end of the driver.

Optionally, the driver comprises a shunt bypass circuit configured parallel across the second transistor, between the line and the ground, at the output end of the driver, wherein the controller is configured to issue a third actuation signal to activate the shunt bypass circuit, which correspondingly deactivates the second transistor and further enables flow or discharge of voltage or current from the output end of the line to the ground via the shunt bypass circuit.

Optionally, the driver comprises a first current limiter circuit configured in the line at an input end of the driver, wherein the controller is configured to issue a first control signal that enables the first current limiter circuit to limit the flow of current through the line in a predefined current range based on a mode selected from the first mode and the second mode.

Optionally, during the first mode, the predefined current range of the first current limiter is selected at a first current level or a second current level based on the voltage level of the electrical power signals to be supplied via the line, wherein the first current level is less than the second current level.

Optionally, during the second mode, the predefined current range of the first current limiter is selected at the first current level.

Optionally, the driver comprises a second current limiter circuit configured between the line and the ground, wherein the controller is configured to issue a second control signal that enables the second current limiter circuit to limit the flow or discharge of the current from the output end of the line to the ground, at one or more predefined current levels.

Optionally, during the second mode, the one or more predefined current levels are selected based on the predefined speed of the power and communication signals to be transmitted via the line.

Optionally, during the second mode, the one or more predefined current levels are selected at a first current level for low-speed operation, and a second current level for high-speed operation, wherein the second current level is greater than the first current level.

Optionally, the input end of the line is connected to a configurable electrical power source, and the output end of the line is connected to one or more loads associated with the field equipment loop, wherein the controller is configured to issue a third control signal to adjust attributes of the electrical power signals being supplied by the power source to the one or more loads via the line during the first mode.

Optionally, the line is configured between a configurable electrical power source, a control panel, and one or more loads associated with the field equipment loop, wherein the controller is configured to issue a fourth control signal to adjust attributes of the power and communication signals transferred between the power source, the control panel, and/or the one or more loads via the line during the second mode.

Optionally, during the first mode, upon the issue of the first actuation signal, the controller is configured to activate the switch and further enable the DAC and the OpAmp to deactivate the first transistor and the second transistor.

Optionally, during the second mode, upon the issue of the second actuation signal, the controller is configured to deactivate the switch and further actuate the DAC to enable the OpAmp to activate the first transistor and/or the second transistor.

Optionally, during the second mode, the controller is configured to deactivate the switch and further actuate the DAC to supply a reference voltage of a predefined voltage level at an input of the OpAmp to activate the first transistor and/or the second transistor.

Optionally, upon selecting the predefined voltage level of the reference voltage above a voltage level at the output end of the line, the OpAmp is configured to deactivate the second transistor and activate the first transistor, which correspondingly sets the predefined voltage level at the output end of the line.

Optionally, to increase the voltage level at the output end of the line from a first level to a second level, the driver enables the DAC to supply the reference voltage equal to the second level to the OpAmp, which deactivates the second transistor and activates the first transistor and correspondingly supplies the second level of voltage at the output end of the line.

Optionally, upon selecting the predefined voltage level of the reference voltage below a voltage level at the output end of the line, the OpAmp is configured to deactivate the first transistor and activate the second transistor, which correspondingly sets the predefined voltage level at the output end of the line.

Optionally, to decrease the voltage level at the output end of the line from a second level to a first level, the driver enables the DAC to supply the reference voltage equal to the first level to the OpAmp, which deactivates the first transistor and activates the second transistor and correspondingly supplies the first level of voltage at the output end of the line.

Optionally, the controller is configured to periodically generate trigger signals at a predefined time interval and correspondingly monitor the generated trigger signals, and actuate the first current limiter circuit to disable the operation of the driver upon non-detection of the generated trigger signals within the predefined time interval.

Optionally, the high-power power electronic switch is selected from any of a P-channel Metal-Oxide-Semiconductor (PMOS) transistor, an N-channel Metal-Oxide-Semiconductor (NMOS) transistor, and a relay, wherein the first transistor and the second transistor is a bipolar junction transistor (BJT).

The preceding summary is illustrative only and is not intended to be in any way limiting on the scope of the invention as defined by the appended claims. In addition to the illustrative aspects, embodiments, and features described above, further aspects, embodiments, features, and techniques of the invention will become more apparent from the following description in conjunction with the drawings.

### BRIEF DESCRIPTION OF THE DRAWINGS

The accompanying drawings are included to provide a further understanding of the invention. The drawings illustrate exemplary embodiments of the invention and, together with the description, serve to explain the principles of the invention.

In the drawings, similar components and/or features may have the same reference label. Further, various components of the same type may be distinguished by following the reference label with a second label that distinguishes among the similar components. If only the first reference label is used in the specification, the description is applicable to any one of the similar components having the same first reference label irrespective of the second reference label.
FIG. 1 illustrates an exemplary block diagram of a system comprising a loop power driver configured in a power and communication line associated with a fire safety system.
FIG. 2 illustrates an exemplary representation depicting functional modules of the loop power driver of FIG. 1.
FIG. 3 illustrates an exemplary flow diagram depicting the operation of the driver during the first (high-power) mode.
FIG. 4 illustrates an exemplary flow diagram depicting the operation of the driver during the second (low-power high-speed) mode.
FIG. 5 illustrates an exemplary flow diagram depicting the switching operation of the driver between the first mode and second mode.

### DETAILED DESCRIPTION

The following is a detailed description of embodiments depicted in the accompanying drawings. The embodiments are in such detail as to clearly communicate the invention. However, the amount of detail offered is not intended to limit the anticipated variations of these embodiments; on the contrary, the intention is to cover all modifications, equivalents, and alternatives of these embodiments falling within the scope of the invention as defined by the appended claims.

Various terms are used herein. To the extent a term used in a claim is not defined below, it should be given the broadest definition persons in the pertinent art have given that term as reflected in printed publications and issued patents at the time of filing.

In the specification, reference may be made to the spatial relationships between various components and to the spatial orientation of various aspects of components as the devices are depicted in the attached drawings. However, as will be recognized by those skilled in the art after a complete reading of the subject disclosure, the components of this invention described herein may be positioned in any desired orientation. Thus, the use of terms such as "above," "below," "upper," "lower," "first", "second" or other like terms to describe a spatial relationship between various components or to describe the spatial orientation of aspects of such components should be understood to describe a relative relationship between the components or a spatial orientation of aspects of such components, respectively, described herein may be oriented in any desired direction.

Fire safety systems are employed to ensure the safety of buildings and their occupants. These systems typically rely on extensive wiring infrastructure to connect various sensors, alarm devices, and control panels. A conventional fire installation may involve the use of two separate pairs of wires: one pair for communication signals and another pair for power supply.

While this traditional wiring scheme is effective, it may introduce several challenges that may increase the complexity and cost of the overall installation. The use of two pairs of wires may necessitate more extensive cabling, which may be both time-consuming and labor-intensive to install. Additionally, the increased quantity of wiring materials may add to the overall expense. The physical complexity of managing multiple wire pairs may also complicate maintenance and troubleshooting tasks, potentially leading to increased downtime and higher service costs.

An alternative approach may involve the use of a common line (single pair of wires) for both power delivery and communication. This method may simplify the wiring infrastructure, reduce material and labor costs, and make the system easier to install and maintain. However, implementing such a solution may present significant technical challenges.

The primary difficulty may lie in the need for a single pair of wires to handle high power levels required by the fire system components while simultaneously supporting high-speed data communication. High power transmission may lead to issues such as increased circuit losses, higher power dissipation, and thermal management concerns. Another important consideration may be to minimize electromagnetic interference (EMI) that may disrupt communication signals or cause malfunction of the fire system components. Achieving robust EMC performance may be essential to ensure the system's reliability and safety.

Thus, there is a need for an innovative solution that may enable the use of a common line (single-pair wire) for both power and communication in fire installations. This invention provides a loop power driver that may address the above-limitations and shortcomings related to high power handling, fast data transfer, circuit losses, power dissipation, and EMI concerns, resulting in an efficient, cost-effective, and reliable functioning of the fire safety system.

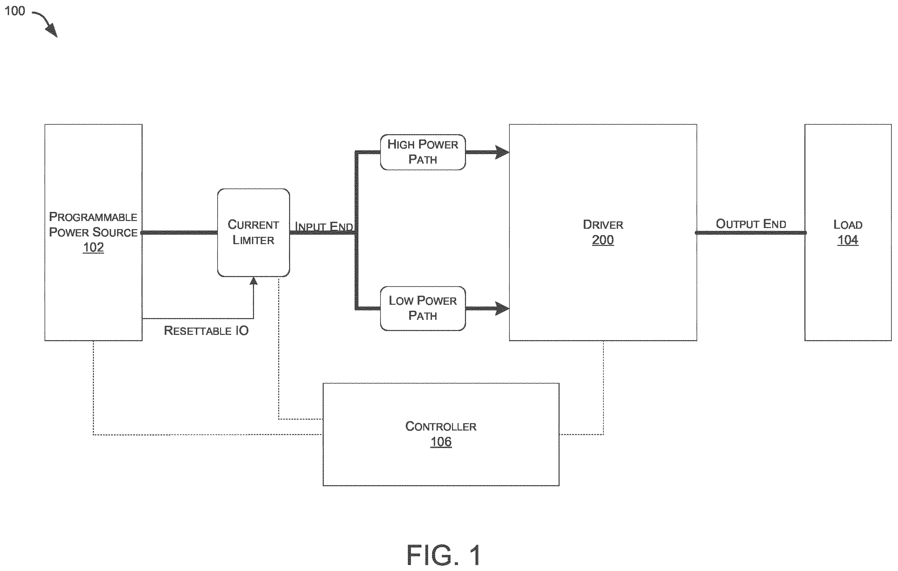

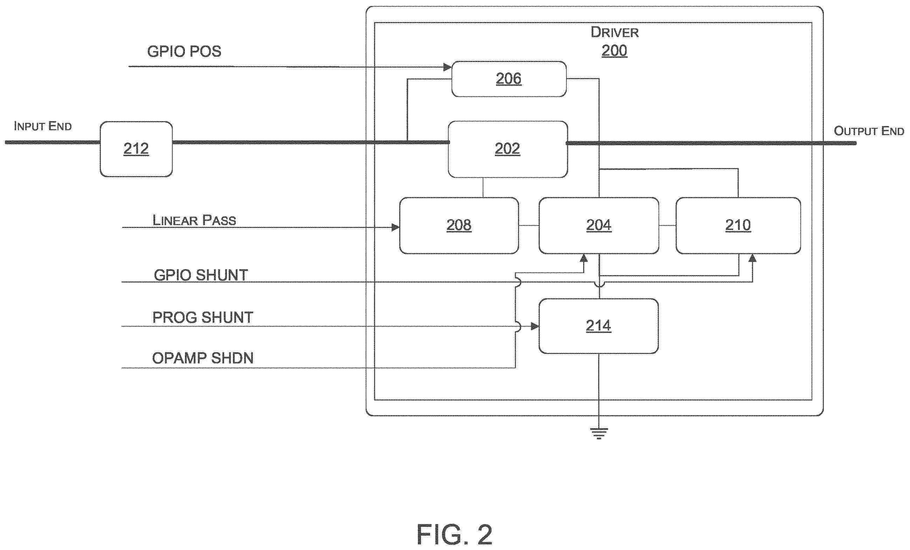

Referring to FIGs. 1 and 2, a loop power driver 200 (also referred to as loop card driver or driver or SLC driver, herein) for enabling communication and power supply functionalities within a fire safety system 100 is disclosed. The driver 200 may include a first transistor 202 (also referred to as pass transistor 202, herein) and a second transistor 204 (also referred to as shunt transistor 204, herein) arranged in a push-pull configuration. Additionally, a high-power electronic switch 206 may be configured in parallel to the first transistor 202. The driver 200 may further include an operational amplifier (OpAmp) 208 having an input terminal connected to a digital-to-analog converter (DAC), and output terminals connected to bases associated with the first transistor 202 and second transistor 204, where the first transistor 202, the second transistor 204, and the OpAmp 208 may form a gain amplifier (Class AB) having a gain with ~13.5 gain which may be operated based on the DAC command.

In one or more embodiments, the high-power power electronic switch 206 may be a P-channel Metal-Oxide-Semiconductor (PMOS) transistor, however, the switch 206 may also be selected from any of an N-channel Metal-Oxide-Semiconductor (NMOS) transistor, and a relay, but is not limited to the like. Further, in one or more embodiments, the first transistor 202 and the second transistor 204 may be bipolar junction transistors (BJT), but are not limited to the like.

The driver 200 is adaptable to be installed to or integrated into a power and communication line (also referred to as source line or line, herein) associated with the fire safety system 100 or a field equipment loop of the fire safety system 100. In this setup, the switch 206 and the first transistor 202 may remain configured in series with the line, while the second transistor 204 may be positioned between the line and ground at the output end (also known as the load end) of the driver 200. As illustrated, the driver 200 may be configured in the line, such that a collector of the first transistor 202 remains connected to the line at an input end (also known as source end) of the driver 200, emitters of the first transistor 202 and the second transistor 204 remain connected to the line at the output end of the driver 200, the switch remains parallel to the first transistor 202 between the collector and the emitter of the first transistor 202, and a collector of the second transistor 204 remains connected to the ground via a current limiter circuit 214 at the output end of the driver 200.

Further, the driver 200 may include a controller 106 that may be connected to the switch 206 and the DAC. In one or more embodiments, the controller 106 may be connected to a gate associated with the PMOS switch 206, with the source of the PMOS switch 206 connected to the input end of the line or a power source 102 and the drain of the PMOS switch 206 connected to the output end of the line. The controller 106 may include a processor with access to a memory storing executable instructions. These instructions may enable the controller 106 to issue specific actuation signals, thereby controlling the operation of the driver 200 in different modes.

It is to be appreciated that various ranges and levels of current and voltages mentioned herein are only exemplary, and these can be changed to a higher number or a lower number without any limitation whatsoever based on the ratings of the power source 102, the connected loads 104, and the components associated with the loop driver 200, all such implementations are well within the scope of the invention.

In the first mode (also referred to as high power mode), the controller 106 may issue a first actuation signal to operate the driver 200, allowing the supply of electrical power signals above a predefined voltage level (high power level ranging from 24 V to 40 V, but not limited to the like) via the line. This mode facilitates the transmission of high-power signals from the power source 102 to the loads 104 such as sensors, alarms, indicators, and control panels associated with the fire safety system 100.

In the second mode (also referred to as low-power, high-speed mode), the controller 106 may issue a second actuation signal to operate the driver 200, enabling the supply of power and communication signals below the predefined voltage level (low power level ranging from 24 V to 0 V, but not limited to the like) and at a predefined speed up to 8kbps via the line. This mode is optimized for efficient communication and lower power consumption, ideal for applications requiring both power supply and data transmission capabilities.

In one or more embodiments, the driver 200 may further include a shunt bypass circuit 210 configured parallel across the second transistor 204, between the line and the ground, at the output end of the driver 200. In one or more embodiments, the controller 106 may be configured to issue a third actuation signal to activate the shunt bypass circuit 210, which may correspondingly deactivate the second (shunt) transistor 204 and further enable the flow or discharge of voltage or current from the output end of the line to the ground via the shunt bypass circuit 210. This may facilitate in discharging operation of the load or for reducing the voltage level at the output end of the line to zero.

During the first mode, upon the issue of the first actuation signal, the controller 106 may be configured to activate the PMOS switch 206 and further actuate the DAC that may further command or force the OpAmp 208 to a tristate (High impedance state), thereby deactivating the first transistor 202 and the second transistor 204. In such embodiments, the controller 106 may create a forward bias across the PMOS switch 206 such that the PMOS switch 206 operates in a linear or saturation region. Further, the OpAmp 208 may create a reverse bias across the first transistor 202 and the second transistor 204 to keep them deactivated. Furthermore, in some instances during the first mode, the first transistor 202 may remain or be kept activated, with the second transistor 204 deactivated. However, as the PMOS switch 206 is operating in the linear or saturation region, the PMOS switch 206 may get turned ON which may create a short circuit path across the first transistor 202, thereby allowing the flow of electrical power through the line via the PMOS switch 206 with substantially no flow of electrical power via the first transistor 202.

Further, during the second mode, the controller 106 may be configured to deactivate the switch 206 and further actuate the DAC to supply a reference voltage of a predefined voltage level to the OpAmp 208, to activate the first transistor 202 and/or the second transistor 204. This predefined voltage level (DAC command) may correspond to the voltage level to be maintained or supplied at the output end of the line. In such embodiments, the controller 106 may create a reverse bias across the PMOS switch 206 such that the PMOS switch 206 operates as an open circuit. Further, the OpAmp 208 may create a forward bias across the first transistor 202 and/or the second transistor 204 to keep them activated/turned ON and operating in a linear or saturation region.

In one or more embodiments, the driver 200 may further include a first current limiter circuit 212 configured in the line at an input end of the driver 200. The controller 106 may be configured to issue a first control signal that may enable the first current limiter circuit 212 to limit the flow of current through the line in a predefined current range (~0.5 A to ~4 A) based on the mode (first mode and second mode) of operation of the driver 200. During the first (high power) mode, the predefined current range of the first current limiter circuit 212 may be selected between a first current level (~0.5 A) and a second current level (~4 A) based on the voltage level (low or high) of the electrical power signals to be supplied via the line. Further, during the second (low power) mode, the predefined current range of the first current limiter circuit 212 may be selected at the first current level (~0.5 A).

In one or more embodiments, the driver 200 may further include a second current limiter circuit 214 configured between the line and the ground at the output end of the line. The controller 106 may be configured to issue a second control signal that may enable the second current limiter circuit 214 to limit the flow or discharge of the current from the output end of the line to the ground, at one or more predefined current levels. During the second mode, the predefined current levels may be selected based on the speed of the power and communication signals to be supplied via the line. For instance, the predefined current levels may be selected at a first current level (~0.5 A) for low-speed transfer of the power and communication signals via the line. Further, the predefined current levels may be selected at a second current level (~4 A) for high-speed transfer of the power and communication signals via the line, where the second current level may be greater than the first current level.

In one or more embodiments, the power source 102 at the input end of the line may be a configurable or programmable electrical power source 102. The controller 106 may be configured to issue a third control signal to adjust the attributes of the electrical power signals being supplied by the programmable power source 102 to the loads 104 via the line during the first (high power) mode.

In one or more embodiments, the controller 106 may be a microcontroller that may be connected to the gate of the PMOS switch 206, the OpAmp 208, the first current limiter circuit 212, the second current limiter circuit 214, and the programable power source 102 using General Purpose Input/Output pins or ports associated with the microcontroller 106.

Further, in one or more embodiments, the line may be configured between the programmable electrical power source 102, a control panel, and the loads 104 associated with the field equipment loop. In such embodiments, the controller 106 may be configured to issue a fourth control signal to adjust the attributes of the power and communication signals transferred between the power source 102, the control panel, and/or the loads 104 via the line during the second mode.

In one or more embodiments, during the second (low power high speed) mode, the controller 106 may be configured to deactivate the switch and further actuate the DAC to supply a reference voltage of a predefined voltage level at an input of the OpAmp 208 to activate the first transistor 202 and/or the second transistor 204.

In one or more embodiments, upon selecting the predefined voltage level of the reference voltage above a real-time voltage level at the output end of the line during the second (low power high speed) mode, the OpAmp 208 may deactivate the second transistor 204 and activate the first transistor 202, which may correspondingly set the predefined voltage level at the output end of the line. Accordingly, during the second (low power high speed) mode, to increase the voltage level at the output end of the line from a first level to a second level, the driver 200 may enable the DAC to supply the reference voltage equal to the second level to the OpAmp 208, which may deactivate the second transistor 204 and activate the first transistor 202, and correspondingly supply the second level of voltage at the output end of the line. For instance, if the voltage level at the output end is 6 V and a reference voltage of 12 V is applied by the DAC at the input of the OpAmp 208, the first transistor 202 may get activated and the second transistor 204 may get deactivated, to change voltage level at the output end from 6 V to 12 V.

Further, in one or more embodiments, upon selecting the predefined voltage level of the reference voltage below a real-time voltage level at the output end of the line during the second (low power high speed) mode, the OpAmp 208 may deactivate the first transistor 202, and activate the second transistor 204, which may correspondingly set the predefined voltage level at the output end of the line. Accordingly, during the second (low power high speed) mode, to decrease the voltage level at the output end of the line from a second level to a first level, the driver 200 may enable the DAC to supply the reference voltage equal to the first level to the OpAmp 208, which may deactivate the first transistor 202 and activate the second transistor 204, and correspondingly supply the first level of voltage at the output end of the line.

In one or more embodiments, in a non-limiting example, during output high voltage to lower voltage transition (example 20 V to 0 V transition), the controller 106 may actuate the DAC to command a reference voltage change from 1.48 V to 0 V (but not limited to the like), such that the base of the first (pass) transistor 202 remains at lower potential compared to the emitter, thereby becoming reverse biased or open circuited. However, the base of the second (shunt) transistor 204 remains at a lower potential compared to the emitter to activate and operate it (forward-biased) in a linear or saturation region which may turn ON the second transistor 204, thereby allowing the second transistor 204 to bring the output voltage to the commanded lower potential, which is referred to as discharging. During discharge conditions, the discharge current may flow through the second transistor 204. Further, the shunt circuit (second current limiter circuit) 214 may limit the flow of current to either 0.5 A or 4 A as per the configuration. Accordingly, the second current limiter circuit 214 may prevent EMI concerns while high current flows to the ground. For instance, if the voltage level at the output end is 18 V and a reference voltage of 12 V is applied by the DAC at the input of the OpAmp 208, the second transistor 204 may get activated and the first transistor 202 may get deactivated, to change voltage level at the output end from 18 V to 12 V.

In one or more embodiments, the controller 106 may command the programmable power source 102 to supply a power or voltage level greater than the voltage level to be supplied at the output end of the line, considering the voltage drop across the first transistor 202 and other components associated with the driver 200. For instance, in a non-limiting example, to have an output voltage of 20 V at the output end of the line, the controller 106 may operate the power source 102 at 24 V, considering a voltage drop of 4 V at the first transistor 202.

In one or more embodiments, the power source 102 may be programmable, allowing for variable voltage configurations based on the output or load requirements, augmented by an additional delta to accommodate path losses. Initially, the power source 102 may provide default power at either a low power (~24 V) or high power (~40 V) level. However, during the mode transitions, specific procedures may be implemented to ensure seamless adjustments or transitions. For instance, while transitioning from a low to high power mode, the controller 106 may ramp up the power source 102 voltage well in advance of the transition, ensuring a smooth transition from the low power (~24 V) level to the requisite higher power (~40 V) level. Conversely, while transitioning from high to low power mode, the controller 106 may ramp down the power source 102 voltage well in advance of the transition, ensuring a smooth transition from a higher power (~40 V) level to low power (~24 V) level. This proactive reduction may minimize power dissipation in the line and the driver 200, compensating for higher losses encountered in the low-power high-speed mode, thus optimizing overall system 100 efficiency.

In one or more embodiments, the driver 200 may be configured with a resettable IO firmware control that is used to ensure the failsafe operation, which may allow a periodic trigger signals generation by the controller 106 at a predefined time such as but not limited to 8 msec (may be adjusted) for normal operation and monitor the generated trigger signals. If the trigger is not generated in 8 msec, then the controller 106 may actuate the first current limiter circuit 212 to disable the flow of current through the line, thereby disabling the output to operate in a safe state (OFF state).

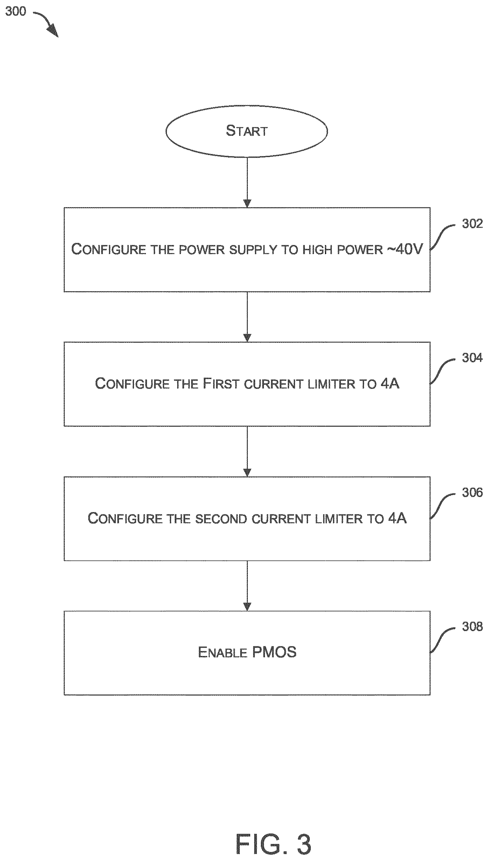

Referring to FIG. 3, during the first (high-power mode), the power source 102 may be configured at ~40 V at block 302, and the current level of the first current limiter circuit 212 and the second current limiter circuit 214 may be set at ~4 A at blocks 304 and 306, respectively. Further, at block 308, the PMOS switch 206 may be activated, while actuating the DAC that may further command or force the OpAmp 208 to a tristate (high impedance state), thereby deactivating the first transistor 202 and the second transistor 204. Accordingly, a forward bias may be created across the PMOS switch 206 such that the PMOS switch 206 operates in a linear or saturation region and get turned ON, and the OpAmp 208 may create a reverse bias across the first transistor 202 and the second transistor 204 to keep them deactivated or turned OFF. As a result, the PMOS switch 206 may operate in the linear or saturation region and create a short circuit path across the first transistor, thereby allowing the flow of electrical power through the line via the PMOS switch 206 with substantially no flow of electrical power via the first transistor 202 and supplying ~40 V at the output end of the line.

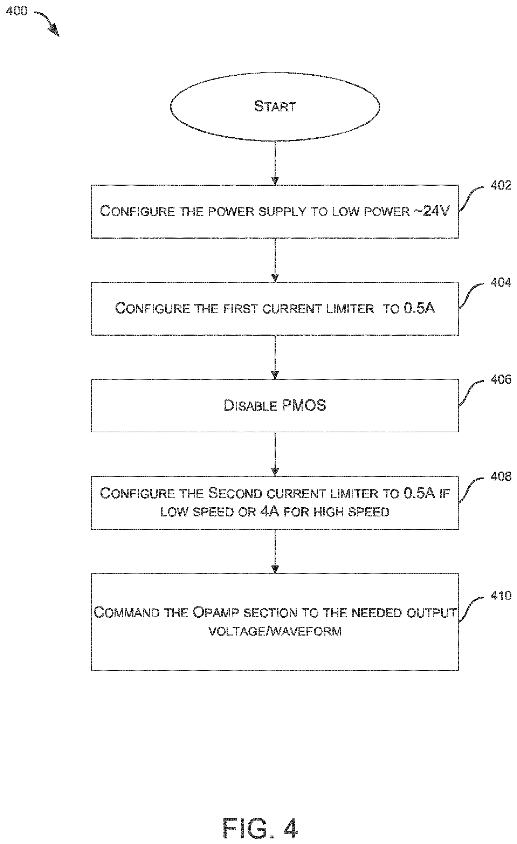

Referring to FIG. 4, during the second (low-power high-speed mode), the power source 102 may be configured at ~24 V at block 402, and the current level of the first current limiter circuit 212 may be set at ~0.5 A at block 404. Further, the PMOS 206 may be disabled at block 406. Further, the current level of the second current limiter circuit 214 may be selected at ~0.5 A) for low-speed transfer of the power and communication signals via the line or at ~4 A for high-speed transfer of the power and communication signals via the line. Furthermore, at block 408, the controller 106 may command the OpAmp 208 to activate the first transistor 202 and/or the second transistor 204 to enable the supply of power and communication signals via the line at low-power high-speed.

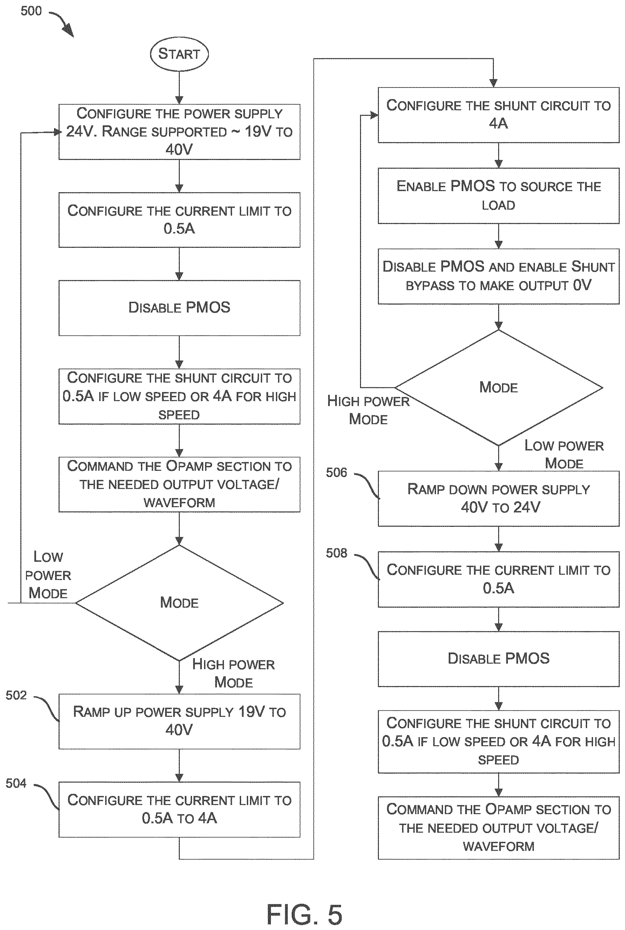

Referring to FIG. 5, while transitioning from the first (low-power high-speed) mode to the second (high-power) mode, the controller 106 may ramp up voltage of the power source 102 well in advance of the transition at block 502 and change the first current limiter circuit 212 from 0.5 A to 4 A at block 504, ensuring a smooth transition from the low power (~24 V) level to the requisite higher power (~40 V) level. Conversely, while transitioning from second (low-power high-speed) mode to first (high-power mode), the controller 106 may ramp down voltage of the power source 102 well in advance of the transition at block 506 and change the first current limiter circuit 212 from 4 A to 0.5 A at block 508, ensuring a smooth transition from a higher power (~40 V) level to low power (~24 V) level. This proactive reduction may minimize power dissipation in the line and the driver, compensating for higher losses encountered in the low-power high-speed mode, thus optimizing overall system efficiency.

Thus, this invention provides an improved solution in the form of the loop power driver that may enable the use of a common line (single-pair wire) for both power and communication in fire installations. This loop driver addresses the technical hurdles related to high power handling, fast switching, circuit losses, power dissipation, and EMC concerns, ultimately resulting in a more streamlined, cost-effective, and reliable fire safety system.

Although the invention has been explained considering that the loop driver's 200 operation is controlled by a controller 106 such as a microcontroller, it may be understood that the loop driver's 200 operation may also be controlled by a variety of computing systems, such as a computer, a server, a network server, a cloud-based environment, a Field Programmable Gate Arrays (FPGA), and the like. The controller 200 comprises one or more processors operatively coupled to a memory. The processors may be implemented as one or more microprocessors, microcomputers, microcontrollers, digital signal processors, central processing units, logic circuitries, and/or any devices that manipulate data based on operational instructions. Among other capabilities, the processors are configured to fetch and execute computer-readable instructions stored in the memory. The memory may store one or more computer-readable instructions or routines, which may be fetched and executed to create or share the data units over a network service. The memory may comprise any non-transitory storage device including, for example, volatile memory such as RAM, or non-volatile memory such as EPROM, flash memory, and the like. The controller 106, the loop driver 200, the power source 102, the loads 104, and the source line may comprise interfaces that may comprise a variety of interfaces for connecting the corresponding components and facilitating communication and power and communication signals exchange between them.

While the invention has been described with reference to exemplary embodiments, it will be understood by those skilled in the art that various changes may be made and equivalents may be substituted for elements of the described embodiments without departing from the scope of the invention as defined by the appended claims. Modifications may be made to adapt a particular situation or material to the teachings herein without departing from the scope of the invention. Therefore, it is intended that the invention not be limited to the particular embodiment disclosed, but that the invention includes all embodiments falling within the scope of the appended claims.

In interpreting the specification, all terms should be interpreted in the broadest possible manner consistent with the context. In particular, the terms "comprises" and "comprising" should be interpreted as referring to elements, components, or steps in a nonexclusive manner, indicating that the referenced elements, components, or steps may be present, or utilized, or combined with other elements, components, or steps that are not expressly referenced. Where the claims refer to at least one of something selected from the group consisting of A, B, C ....and N, the text should be interpreted as requiring only one element from the group, not A plus N, or B plus N, etc.

## Claims

1. A loop power driver (200) for communication and power supply, the loop power driver comprising:
a first transistor (202) and a second transistor (204) configured in a push-pull configuration;
a high-power electronic switch (206) configured parallel to the first transistor;
an operational amplifier, OpAmp, (208) comprising an input terminal connected to a digital-to-analog converter, DAC, and output terminals connected to bases associated with the first transistor and the second transistor;
wherein the driver is adapted to be configured in a power and communication line associated with a field equipment loop, such that the switch and the first transistor remain configured in series with the line, and the second transistor remains configured between the line and ground at an output end of the driver; and
a controller (106) connected to the switch and the DAC, wherein the controller comprises a processor with access to a memory storing instructions executable by the processor, which causes the controller to:
issue a first actuation signal to operate the driver in a first mode that enables supply of electrical power signals above a predefined voltage level via the line; and
issue a second actuation signal to operate the driver in a second mode that enables supply of power and communication signals below the predefined voltage level and at a predefined speed via the line.

2. The loop power driver of claim 1, wherein the driver is configured in the line, such that a collector of the first transistor remains connected to the line at an input end of the driver, emitters of the first transistor and the second transistor remain connected to the line at the output end of the driver, the switch remains parallel to the first transistor between the collector and the emitter of the first transistor, and a collector of the second transistor remains connected to the ground at the output end of the driver.

3. The loop power driver of claim 1 or 2, wherein the driver comprises a shunt bypass circuit (210) configured parallel across the second transistor, between the line and the ground, at the output end of the driver, wherein the controller is configured to issue a third actuation signal to activate the shunt bypass circuit, which correspondingly deactivates the second transistor and further enables flow or discharge of voltage or current from the output end of the line to the ground via the shunt bypass circuit.

4. The loop power driver of claim 1, 2 or 3, wherein the driver comprises a first current limiter circuit (212) configured in the line at an input end of the driver, wherein the controller is configured to issue a first control signal that enables the first current limiter circuit to limit the flow of current through the line in a predefined current range based on a mode selected from the first mode and the second mode.

5. The loop power driver of claim 4, wherein the controller is configured to:
periodically generate trigger signals at a predefined time interval, and monitor the generated trigger signals; and
actuate the first current limiter circuit to disable the operation of the driver upon non-detection of the generated trigger signals within the predefined time interval.

6. The loop power driver of claim 4 or 5, wherein during the first mode, the predefined current range of the first current limiter is selected at a first current level or a second current level based on a voltage level of the electrical power signals to be supplied via the line, wherein the first current level is less than the second current level, and optionally wherein during the second mode, the predefined current range of the first current limiter is selected at the first current level.

7. The loop power driver of any preceding claim, wherein the driver comprises a second current limiter circuit (214) configured between the line and the ground, wherein the controller is configured to issue a second control signal that enables the second current limiter circuit to limit the flow or discharge of the current from the output end of the line to the ground, at one or more predefined current levels.

8. The loop power driver of claim 7, wherein during the second mode, the one or more predefined current levels are selected based on the predefined speed of the power and communication signals to be transmitted via the line, and optionally wherein during the second mode, the one or more predefined current levels are selected at:
a first current level for low-speed operation; and
a second current level for high-speed operation, wherein the second current level is greater than the first current level.

9. The loop power driver of any preceding claim, wherein the input end of the line is connected to a configurable electrical power source (102) and the output end of the line is connected to one or more loads (104) associated with the field equipment loop, wherein the controller is configured to issue a third control signal to adjust attributes of the electrical power signals being supplied by the power source to the one or more loads via the line during the first mode.

10. The loop power driver of any preceding claim, wherein the line is configured between a configurable electrical power source (102), a control panel, and one or more loads (104) associated with the field equipment loop, wherein the controller is configured to issue a fourth control signal to adjust attributes of the power and communication signals transferred between the power source, the control panel, and/or the one or more loads via the line during the second mode.

11. The loop power driver of any preceding claim, wherein during the first mode, upon the issue of the first actuation signal, the controller is configured to activate the switch and further enable the DAC and the OpAmp to deactivate the first transistor and the second transistor, and/or wherein during the second mode, upon the issue of the second actuation signal, the controller is configured to deactivate the switch and further actuate the DAC to enable the OpAmp to activate the first transistor and/or the second transistor.

12. The driver of claim 11, wherein during the second mode, the controller is configured to deactivate the switch and further actuate the DAC to supply a reference voltage of a predefined voltage level at an input of the OpAmp to activate the first transistor and/or the second transistor.

13. The loop power driver of claim 12, wherein upon selecting the predefined voltage level of the reference voltage above a voltage level at the output end of the line, the OpAmp is configured to deactivate the second transistor and activate the first transistor, which correspondingly sets the predefined voltage level at the output end of the line, and optionally wherein to increase the voltage level at the output end of the line from a first level to a second level, the driver enables the DAC to supply the reference voltage equal to the second level to the OpAmp, which deactivates the second transistor and activates the first transistor and correspondingly supplies the second level of voltage at the output end of the line.

14. The loop power driver of claim 12 or 13, wherein upon selecting the predefined voltage level of the reference voltage below a voltage level at the output end of the line, the OpAmp is configured to deactivate the first transistor and activate the second transistor, which correspondingly sets the predefined voltage level at the output end of the line, and optionally wherein to decrease the voltage level at the output end of the line from a second level to a first level, the driver enables the DAC to supply the reference voltage equal to the first level to the OpAmp, which deactivates the first transistor and activates the second transistor and correspondingly supplies the first level of voltage at the output end of the line.

15. The loop power driver of any preceding claim, wherein the high-power power electronic switch is selected from any of: a P-channel Metal-Oxide-Semiconductor (PMOS) transistor, an N-channel Metal-Oxide-Semiconductor (NMOS) transistor, and a relay, and wherein the first transistor and the second transistor is a bipolar junction transistor (BJT).
